(19) Europäisches Patentamt / European Patent Office / Office européen des brevets

(11) **EP 3 731 267 B1**

(12) **EUROPEAN PATENT SPECIFICATION**

(45) Date of publication and mention
of the grant of the patent:
**27.05.2026 Bulletin 2026/22**

(21) Application number: **19171080.5**

(22) Date of filing: **25.04.2019**

(51) International Patent Classification (IPC):
*H01L 23/049* (2006.01)    *H01L 23/24* (2006.01)
*H01L 23/373* (2006.01)    *H01L 23/498* (2006.01)

(52) Cooperative Patent Classification (CPC):
**H10W 76/136; H10W 74/473; H10W 76/47;**
H10W 40/255; H10W 72/5363; H10W 72/884;
H10W 74/00; H10W 90/701; H10W 90/734;
H10W 90/754

(54) **SEMICONDUCTOR MODULE AND METHOD FOR PRODUCING THE SAME**

HALBLEITERMODUL UND VERFAHREN ZUR HERSTELLUNG DAVON

MODULE SEMICONDUCTEUR ET SON PROCÉDÉ DE FABRICATION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**28.10.2020 Bulletin 2020/44**

(73) Proprietor: **Infineon Technologies AG
85579 Neubiberg (DE)**

(72) Inventor: **TRICHY RENGARAJAN,
Gopalakrishnan
59557 Lippstadt (DE)**

(74) Representative: **Westphal, Mussgnug & Partner,
Patentanwälte mbB
Werinherstraße 79
81541 München (DE)**

(56) References cited:
EP-A1- 1 933 610          EP-A1- 3 276 660
EP-A1- 3 511 977          JP-A- H0 529 663
JP-A- H10 107 082         JP-A- H10 270 609
JP-B2- 4 151 634          US-A1- 2002 070 439
US-A1- 2004 212 970       US-A1- 2008 258 316
US-A1- 2023 115 449

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

TECHNICAL FIELD

The instant disclosure relates to a semiconductor module and a method for producing the same.

BACKGROUND

Power semiconductor module arrangements often include at least one semiconductor substrate arranged in a housing. A semiconductor arrangement including a plurality of controllable semiconductor elements (e.g., two IGBTs in a half-bridge configuration) is arranged on each of the at least one substrate. Each substrate usually comprises a substrate layer (e.g., a ceramic layer), a first metallization layer deposited on a first side of the substrate layer and a second metallization layer deposited on a second side of the substrate layer. The controllable semiconductor elements are mounted, for example, on the first metallization layer. The second metallization layer may optionally be attached to a base plate. The controllable semiconductor devices are usually mounted on the semiconductor substrate by soldering or sintering techniques.

Document US 2002/070439 A1 discloses a silicone resin for sealing a semiconductor chip. A cured silicone resin, which is obtained by curing the silicone resin at a given temperature, has a number of percent elongation after fracture measured at a room temperature not less than 4% of a penetration number at a room temperature. A semiconductor device sealed with the silicone resin, when applied to a heat cycle or a vibration test, provides resistances to cracking, voiding, or interfacial peeling-off. The cured silicone resin may have a penetration number not less than 10 and not more than 80 and a loss elasticity not less than 17% of the storage elasticity. A resin member made of the cured silicone resin and sealing a semiconductor chip may include a filler, such as silica or alumina, of which coefficient of linear thermal expansion is lower than that of the cured silicone resin.

Document EP 1 933 610 A1 discloses a substrate structure including a substrate, a plurality of electronic components mounted along the substrate, and a resin part coating each electronic component with a resin while kept in close contact with the substrate. The substrate structure includes a frame body surrounding each electronic component while kept in close contact with the substrate and a lid part closing an opening in the frame body, and a resin is filled inside the frame body.

Document EP 3 276 660 A1 discloses a power semiconductor module including a module housing, a substrate, and a semiconductor chip that is attached to the substrate. The semiconductor chip is disposed in the module housing. A dielectric first encapsulation is disposed in the module housing, in physical contact with both the semiconductor chip and the substrate and has a first modulus of elasticity. A dielectric second encapsulation is disposed in the module housing and has a second modulus of elasticity. The first encapsulation is a polymer and disposed between the substrate and the second encapsulation. The semiconductor chip is disposed between the first encapsulation and the substrate. Further, the first modulus of elasticity is greater than the second modulus of elasticity.

Document EP 3 511 977 A1 discloses a method for producing a power semiconductor module arrangement comprising forming a pre-layer by depositing inorganic filler on a first surface within a housing, wherein the inorganic filler is impermeable for corrosive gases. The method further comprises filling casting material into the housing, thereby filling any spaces present in the inorganic filler of the pre-layer with the casting material, and hardening the casting material, thereby forming a first layer.

Electrical lines or electrical connections are used to connect different semiconductor devices of the power semiconductor arrangement. Such electrical lines and electrical connections may include metal and/or semiconductor material. The housings of power semiconductor module arrangements are generally permeable to gases to a certain extent. Some gases such as sulfur containing gases, for example, may react with metallic components inside the housing. This leads to a chemical degradation of these components which may result in a failure of individual components and ultimately of the whole semiconductor arrangement.

Therefore, the components inside the housing are usually protected against corrosion by encapsulating the components. Different materials are known that are suitable to protect the components inside the housing against corrosion. However, such materials may have a different coefficient of thermal expansion (CTE) than the substrate and the elements that are mounted on the substrate. Further, encapsulation materials that are used to reduce the CTE mismatch may cause a high stresses within the housing.

There is a need for a power semiconductor module wherein the semiconductor components are protected against corrosion, and wherein a CTE mismatch between different components as well as internal stresses are reduced, such that the overall lifetime of the power semiconductor module arrangement is increased.

SUMMARY

The invention is set out in the appended set of claims.

The invention may be better understood with reference to the following drawings and the description. The components in the figures are not necessarily to scale, emphasis instead being placed upon illustrating the principles of the invention. Moreover, in the figures, like referenced numerals designate corresponding parts throughout the different views.

BRIEF DESCRIPTION OF THE DRAWINGS

Figure 1 is a cross-sectional view of a power semiconductor module arrangement.
Figure 2 is a cross-sectional view of another power semiconductor module arrangement.
Figure 3, including Figures 3A to 3D, illustrates steps of a method for producing a power semiconductor module arrangement according to one example.
Figure 4 exemplarily illustrates the resulting forces occurring at interfaces between different elements and an encapsulation material.

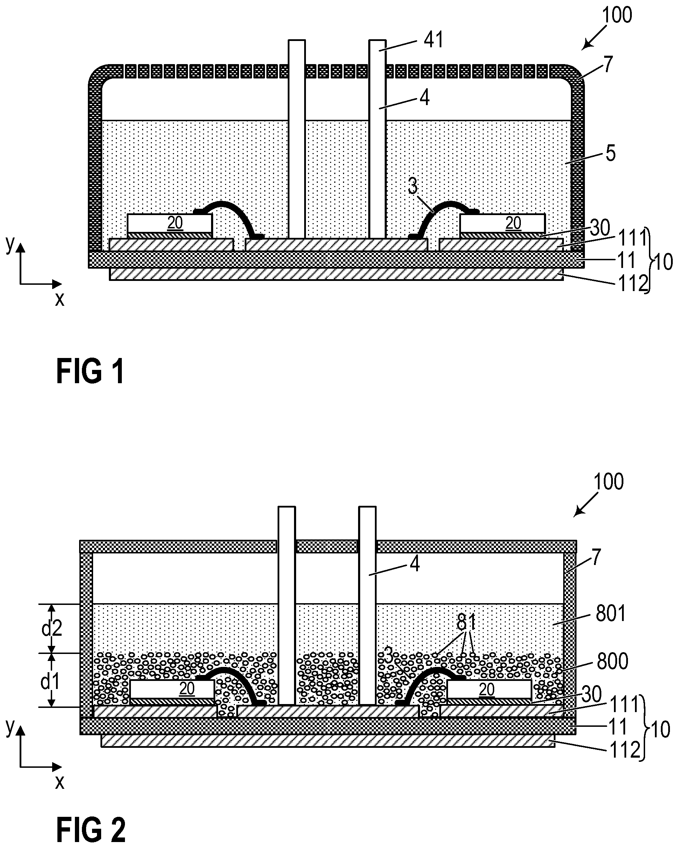

Fig.1 does not fall within the scope of the claims.
Figs. 2 - 4 fall within the scope of the claims.

DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. In the description, as well as in the claims, designations of certain elements as "first element", "second element", "third element" etc. are not to be understood as enumerative. Instead, such designations serve solely to address different "elements". That is, e.g., the existence of a "third element" does not require the existence of a "first element" and a "second element". An electrical line or electrical connection as described herein may be a single electrically conductive element, or include at least two individual electrically conductive elements connected in series and/or parallel. Electrical lines and electrical connections may include metal and/or semiconductor material, and may be permanently electrically conductive (i.e., non-switchable). A semiconductor body as described herein may be made from (doped) semiconductor material and may be a semiconductor chip or be included in a semiconductor chip. A semiconductor body has electrically connecting pads and includes at least one semiconductor element with electrodes.

Referring to Figure 1, wherein Fig. 1 does not fall within the scope of the claims, a cross-sectional view of a power semiconductor module arrangement 100 is schematically illustrated. The power semiconductor module arrangement 100 includes a housing 7 and a semiconductor substrate 10. The semiconductor substrate 10 includes a dielectric insulation layer 11, a (structured) first metallization layer 111 attached to the dielectric insulation layer 11, and a second (structured) metallization layer 112 attached to the dielectric insulation layer 11. The dielectric insulation layer 11 is disposed between the first and second metallization layers 111, 112.

Each of the first and second metallization layers 111, 112 may consist of or include one of the following materials: copper; a copper alloy; aluminum; an aluminum alloy; any other metal or alloy that remains solid during the operation of the power semiconductor module arrangement. The semiconductor substrate 10 may be a ceramic substrate, that is, a substrate in which the dielectric insulation layer 11 is a ceramic, e.g., a thin ceramic layer. The ceramic may consist of or include one of the following materials: aluminum oxide; aluminum nitride; zirconium oxide; silicon nitride; boron nitride; or any other dielectric ceramic. For example, the dielectric insulation layer 11 may consist of or include one of the following materials: $Al_2O_3$, AlN, SiC, BeO or $Si_3N_4$. For instance, the substrate 10 may, e.g., be a Direct Copper Bonding (DCB) substrate, a Direct Aluminum Bonding (DAB) substrate, or an Active Metal Brazing (AMB) substrate. Further, the substrate 10 may be an Insulated Metal Substrate (IMS). An Insulated Metal Substrate generally comprises a dielectric insulation layer 11 comprising (filled) materials such as epoxy resin or polyimide, for example. The material of the dielectric insulation layer 11 may be filled with ceramic particles, for example. Such particles may comprise, e.g., $Si_2O$, $Al_2O_3$, AlN, or BrN and may have a diameter of between about $1\mu$m and about $50\mu$m. The substrate 10 may also be a conventional printed circuit board (PCB) having a non-ceramic dielectric insulation layer 11. For instance, a non-ceramic dielectric insulation layer 11 may consist of or include a cured resin.

The semiconductor substrate 10 is arranged in a housing 7. In the example illustrated in Figure 1, the semiconductor substrate 10 forms a ground surface of the housing 7, while the housing 7 itself solely comprises sidewalls and a cover. This is, however, only an example. It is also possible that the housing 7 further comprises a ground surface and the semiconductor substrate 10 be arranged inside the housing 7. According to another example, the semiconductor substrate 10 may be mounted on a base plate (not illustrated). In some power semiconductor module arrangements 100, more than one semiconductor substrate 10 is arranged on a single base plate. The base plate may form a ground surface of the housing 7, for example.

One or more semiconductor bodies 20 may be arranged on the semiconductor substrate 10. Each of the semiconductor bodies 20 arranged on the semiconductor substrate 10 may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), or any other suitable semiconductor element.

The one or more semiconductor bodies 20 may form a semiconductor arrangement on the semiconductor substrate 10. In Figure 1, only two semiconductor bodies 20 are exemplarily illustrated. The second metallization layer 112 of the semiconductor substrate 10 in Figure 1 is a continuous layer. The first metallization layer 111 is a structured layer in the example illustrated in Figure 1. "Structured layer" means that the first metallization layer 111 is not a continuous layer, but includes recesses between different sections of the layer. Such recesses are schematically illustrated in Figure 1. The first metallization layer 111 in this example includes three different sections. This, however, is only an example. Any other number of sections is possible. Different semiconductor bodies 20 may be mounted on the same or to different sections of the first metallization layer 111. Different sections of the first metallization layer may have no electrical connection or may be electrically connected to one or more other sections using, e.g., bonding wires 3. Electrical connections 3 may also include connection plates or conductor rails, for example, to name just a few examples. The one or more semiconductor bodies 20 may be electrically and mechanically connected to the semiconductor substrate 10 by an electrically conductive connection layer 30. Such an electrically conductive connection layer may be a solder layer, a layer of an electrically conductive adhesive, or a layer of a sintered metal powder, e.g., a sintered silver powder, for example.

According to other examples, it is also possible that the second metallization layer 112 is a structured layer. It is further possible to omit the second metallization layer 112. It is also possible that the first metallization layer 111 is a continuous layer, for example.

The power semiconductor module arrangement 100 illustrated in Figure 1 further includes terminal elements 4. The terminal elements 4 are electrically connected to the first metallization layer 111 and provide an electrical connection between the inside and the outside of the housing 7. The terminal elements 4 may be electrically connected to the first metallization layer 111 with a first end, while a second end 41 of the terminal elements 4 protrudes out of the housing 7. The terminal elements 4 may be electrically contacted from the outside at their second end 41. The terminal elements 4 illustrated in Figure 1, however, are only examples. Terminal elements 4 may be implemented in any other way and may be arranged anywhere within the housing 7. For example, one or more terminal elements 4 may be arranged close to or adjacent to the sidewalls of the housing 7. Terminal elements 4 could also protrude through the sidewalls of the housing 7 instead of through the cover. Any other suitable implementation is possible.

The semiconductor bodies 20 each may include a chip pad metallization (not specifically illustrated), e.g., a source, drain, anode, cathode or gate metallization. A chip pad metallization generally provides a contact surface for electrically connecting the semiconductor body 20. The chip pad metallization may electrically contact a connection layer 30, a terminal element 4, or an electrical connection 3, for example. A chip pad metallization may consist of or include a metal such as aluminum, copper, gold or silver, for example. The electrical connections 3 and the terminal elements 4 may also consist of or include a metal such as copper, aluminum, gold, or silver, for example.

The above mentioned components, as well as other components of the power semiconductor module arrangement 100 inside the housing 7, may corrode when they come into contact with corrosive gases. Corrosive gases may include, e.g., sulfur or sulfur-containing compounds such as hydrogen sulfide $H_2S$, for example. Corrosive gases in the surrounding area of the power semiconductor module arrangement 100 may penetrate into the inside of the housing 7. The housings 7 that are used for power semiconductor module arrangements 100 are usually not fully protected against intruding gases. Further, corrosive gases may enter the housing 7 when the housing 7 is opened or before the housing 7 is closed, for example. Inside the housing 7, the corrosive gases may form acids or solutions, for example, in combination with moisture that may be present inside the housing 7. The corrosive gases or the resulting solutions may cause a corrosion of some or all of the different components. During the corrosion process, the metallic constituents of the components may be oxidized to their respective sulfides. The sulfide formation may alter the electrical properties of the components or may result in the formation of new conductive connections and in short circuits within the power semiconductor module arrangement 100.

Further, when exposed to corrosive gases and further under the influence of electric fields and possibly moisture, dendritic structures may form from mobile metal ions (e.g., Cu, Ag, etc.) of the metal comprising components and structures of the power semiconductor module arrangement 100 and anions (e.g., $S^{2-}$) that are present in the corrosive gas. A dendrite is a characteristic tree-like structure of crystals. Dendritic growth in metal layers has large consequences with regard to material properties and is generally unwanted

Examples for corrosive gases are hydrogen sulfide ($H_2S$), carbonyl sulfide (OCS), or gaseous sulfur (Ss). In some applications, the power semiconductor module arrangement may be exposed to corrosive gases such as $Cl^-$, $SO_x$, or $NO_x$, for example. Generally, it is also possible that sulfur gets to the inside of the housing 7 as constituent of a solid material or liquid.

Components and structures including one or more metals such as copper (e.g., first metallization layer 111, electrical connection 3, terminal element 4, connection layer 30, chip pad metallization), silver (e.g., first metallization layer 111, electrical connection 3, terminal element 4, connection layer 30, chip pad metallization), or lead (e.g. connection layer 30 including leaded solder), may be particularly sensitive to corrosion. Other metals such as aluminum, for example, may have a thin oxide layer covering their surface area, which may provide at least a certain amount of protection against corrosive gases.

Conventional power semiconductor module arrangements 100 generally further include a casting compound 5. The casting compound 5 may consist of or include a silicone gel or may be a rigid molding compound, for example. The casting compound 5 may at least partly fill the interior of the housing 7, thereby covering the components and electrical connections that are arranged on the semiconductor substrate 10. The terminal elements 4 may be partly embedded in the casting compound 5. At least their second ends 41, however, are not covered by the casting compound 5 and protrude from the casting compound 5 through the housing 7 to the outside of the housing 7. The casting compound 5 is configured to protect the components and electrical connections inside the power semiconductor module 100, in particular inside the housing 7, from certain environmental conditions and mechanical damage. The casting compound 5 further provides for an electrical isolation of the components inside the housing 7. However, corrosive gases are usually able to penetrate through the casting compound 5. The casting compound 5, therefore, is usually not able to protect the components and electrical connections from corrosive gases.

The casting compound 5 may form a protective layer in a vertical direction y of the semiconductor substrate 10. The vertical direction y is a direction that is essentially perpendicular to a top surface of the semiconductor substrate 10. The top surface of the semiconductor substrate 10 is a surface on which semiconductor bodies 20 are or may be mounted. The first protective layer 5 at least partly covers any components that are arranged on the top surface of the semiconductor substrate 10 as well as any exposed surfaces of the semiconductor substrate 10.

To better protect the metallic components of the power semiconductor module arrangement 100 against corrosive gases, the casting compound 5 includes a filler 81 In particular, a filler 81 is mixed into the casting compound 5. The filler 81, however, is not evenly distributed within the casting compound 5. Rather, the semiconductor device comprises a first layer 800 formed by a mixture of filler 81 and casting compound 5, and a second layer 801 comprising only casting compound 5 but no filler 81. The second layer 801 may be arranged above the first layer 800. That is, the first layer 800 may be arranged between the second layer 801 and the semiconductor substrate 10 with the semiconductor bodies 20 mounted thereon.

This is exemplarily illustrated in Figure 2, wherein Fig. 1 falls within the scope of the claims. The filler 81 may be configured to chemically react with corrosive gases, or, in particular, with the sulfur or sulfur-containing compounds of corrosive gases. Corrosive gas may also be trapped, adsorbed or absorbed by the filler 81. By chemically reacting with the corrosive gas, the filler 81 prevents the harmful substances from reaching the (metal) components inside the housing 7 and thereby protects the components against corrosion. The filler 81 may be, for example, a powder of a second material which is distributed throughout the first material of the casting compound 5. The second material may include any materials which react with the corrosive gases and which may, e.g., form a metal sulfide when exposed to corrosive gases. The filler 81 may be essentially evenly distributed throughout the first layer 800. The first material of the casting compound 5 may consist of or include a non-reactive cross-linkable or non-cross-linkable polymer such as a silicone gel or silicone rubber, for example. Other casting materials are also possible such as epoxy resin, for example.

The filler 81 is an inorganic filler. Inorganic fillers may include non-melting inorganic materials such as silica, fused silica, crystalline silica, precipitated silica, alumina, beryllium, boron nitride, aluminum nitride, silicon nitride, silicon carbide, boron carbide, titanium carbide, magnesium oxide, zinc oxide, or glass fiber, for example. The filler 81 may be provided in the form of particles with a diameter of between about 1 and 400μm, or between about 4 and 20μm, for example. All of the particles may have the same diameter. However, the particles of the filler 81 do not necessarily all need to have the same diameter. It is also possible to use fillers comprising particles of different sizes. For example, binary systems (particles with two different diameters) or ternary systems (particles with three different diameters) are possible. In this way the packing density of the filler 81 may be increased. In the mixture including the casting compound 5 and the filler 81, that is in the first layer 800, the amount of filler 81 may be between about 20 and 90vol%, or between 60 and 80vol%, for example. Generally speaking, the first layer 800 may include a comparably high amount of filler 81. The particles of the filler 81 may have a comparably high density $\rho_f$ of, e.g., between about 0.9 and 5.0 g/cm³. The casting compound 5, on the other hand, may have a density $\rho_{cc}$ that is lower than the density $\rho_f$ of the filler 81. According to one example, the density $\rho_{cc}$ of the casting compound may be between about 0.2 and 0.9 g/cm³. According to one example, if the density $\rho_f$ of the filler 81 is 0.9 g/cm³, the density $\rho_{cc}$ of the casting compound 5 is < 0.9 g/cm³, or even < 0.5 g/cm³. An aspect ratio of each of the separate particles of the filler 81 may be between 1 and 100, for example.

If the inorganic filler 81 includes an electrically conductive material such as a metallic material, for example, the concentration of the inorganic fillers 81 in the first layer 800 may be such that the first layer 800 as a whole is still electrically insulating.

The first layer 800 may have a first thickness d1 in the vertical direction y. The first layer 800 at least partly covers any components that are arranged on the top surface of the semiconductor substrate 10 as well as any exposed surfaces of the semiconductor substrate 10. The first thickness d1 may be between 1mm and 10mm, or between 2mm and 6mm, for example.

The second layer 801 is arranged on top of the first layer 800. On top of the first layer 800 in this context means that the second layer 801 is arranged adjacent to the first layer 800 in the vertical direction y such that the first layer 800 is arranged between the second layer 801 and the semiconductor substrate 10. The second layer 801 may include a casting material such as a non-reactive, soft cross-linking or non-cross-linking polymer, for example. The non-reactive polymer may include a silicone gel or silicone rubber, for example. Other casting materials are also possible such as epoxy resin, for example. The material of the second layer 801 may be the same as the first material of the first layer 800. The second layer 801 may have a second thickness d2 in the vertical direction y. The second thickness d2 may be the same, smaller or may be greater than the first thickness d1. For example, the second thickness d2 may be between 1mm and 10mm, or between 2mm and 6mm.

As is illustrated in the example of Figure 2, only a bottom of the housing 7 of the power semiconductor module arrangement 100 may be filled with the first layer 800 including both the first material and the filler 81. The height d1 of the first layer 800 is considerably less than the height of the casting compound 5 without filler in the arrangement illustrated in Figure 1, where a major part of the housing 7 is filled with the casting compound 5. The comparably great thickness of the single layer of casting compound 5 of the power semiconductor module arrangement of Figure 1 may result in a deflection of the power semiconductor module arrangement 100, in particular, in a deflection of the semiconductor substrate 10 and/or a base plate (if applicable), especially if the casting compound 5 comprises a so-called hard encapsulant. A hard encapsulant has a hardness that is greater than a certain threshold hardness. The hardness of a material may be determined by means of a Shore durometer, for example, and may be indicated by one of several Shore durometer scales (e.g., Shore type A, Shore type D, etc.). The comparably thin first layer 800 of the power semiconductor module arrangement of Figure 2 generally causes less or even no deflection of the power semiconductor module arrangement 100.

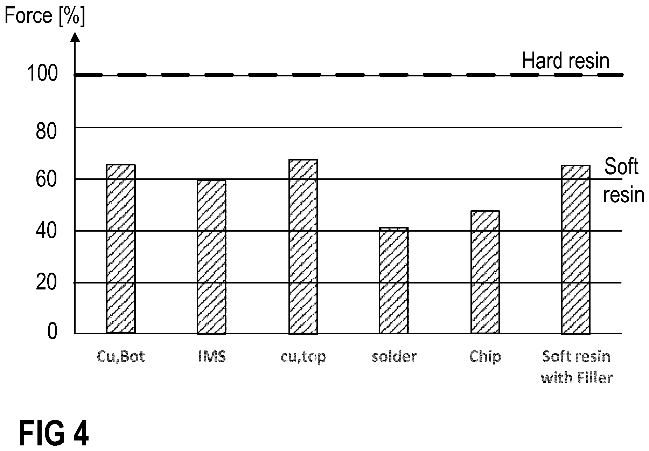

This is exemplarily illustrated by means of Figure 4, which schematically indicates forces that may occur on the surface of different elements of the semiconductor module arrangement. The respective forces occurring on the surfaces of different elements of a semiconductor module arrangement comprising a casting compound 5 (see Figure 1) comprising a hard resin material is indicated as a reference in Figure 4, this force representing 100% in each case. The occurring force may be significantly reduced when using a soft resin instead of a hard resin. For example, a force occurring on the surface of the second metallization layer 112 (Cu, Bot) may be reduced by more than 30% to about 65% when using a soft resin instead of a hard resin. A force occurring on the surface of an IMS substrate (IMS) may be reduced by more than 40% to about 58% when using a soft resin instead of a hard resin. A force occurring on the surface of the first metallization layer 111 (Cu, top) may be reduced by more than 30% to about 68% when using a soft resin instead of a hard resin. A force occurring on the surface of a solder layer 30 (solder) may be reduced by about 60% to about 40% when using a soft resin instead of a hard resin. A force occurring on the surface of a semiconductor body 20 (Chip) may be reduced by more than 50% to about 47% when using a soft resin instead of a hard resin. A force occurring on the surface of the first layer 800 (soft resin with filler) may be reduced by more than 30% to about 63% when using a soft resin instead of a hard resin.

As can be seen, by using a soft encapsulant material and forming a first layer 800 including both the soft encapsulant as well as fillers 81, and a second layer 801 including only the soft encapsulant but no filler 81, the stresses within the semiconductor module may be reduced and the reliability of the whole system may be enhanced. Further, a mismatch of the thermal expansion coefficient CTE between different components of the semiconductor module may be reduced by adding the filler 81 to the casting compound 5 in the first layer 800. For example, the coefficient of thermal expansion $CTE_{800}$ of the first layer 800 may be similar to a coefficient of thermal expansion $CTE_{10}$, $CTE_{20}$ of the semiconductor substrate 10 and the at least one semiconductor body 20 such that, e.g., $CTE_{800} = CTE_{10} \pm 5ppm/K$, and $CTE_{800} = CTE_{20} \pm 5ppm/K$. An unwanted bow of the semiconductor module may be reduced in this way. An unwanted bow generally may occur when different forces occur on different interfaces within the semiconductor module. For example, a base plate and/or the semiconductor substrate 10 of the semiconductor module may be bent to a certain degree, such that the base plate and/or the semiconductor substrate 10 are no longer flat but may have a concave or a convex curvature in the vertical direction y. This may further lead to unwanted tensions on the connections formed within the semiconductor substrate, such as, e.g., the electrically conductive connection layers 30 that are used to mount the semiconductor bodies 20 on the semiconductor substrate 10. Local thermal stresses may lead to a degradation of the casting compound 5.

In an ideal semiconductor module, an equilibrium of forces prevails. That is, $F_1 + F_2 + F_3 + ... + F_i = 0$, where F is the force and i is the number of elements in the semiconductor module. Further, in an ideal semiconductor module, an equilibrium of moments prevails. That is, $M_1 + M_2 + M_3 + ... + Mi = M_{ext}$, where M is the moment and I is the number of elements in the semiconductor module.

A strain continuity of adjacent layers within the semiconductor module may be computed as

$$\alpha_1 + \frac{F_1}{E_1 d_1} + \frac{d_1}{2R} = \alpha_2 + \frac{F_2}{E_2 d_2} - \frac{d_2}{2R}$$

. Or, more generally speaking,

$$\alpha_{i-1} + \frac{F_{i-1}}{E_{i-1} d_{i-1}} + \frac{d_{i-1}}{2R} = \alpha_i + \frac{F_i}{E_i d_i} + \frac{d_i}{2R}$$

,

wherein F is the force, $\alpha$ is the CTE, E is the Modulus, and d is the thickness of a layer in the vertical direction y.

Different layers of the semiconductor module may be the first metallization layer 111, the second metallization layer 112, the dielectric insulation layer 11, the electrically conductive connection layer 30, or the casting compound 5, for example.

The resulting bow of the semiconductor module generally may be adjusted by adjusting the amount of filler 81 in the first layer 801. For example, a greater bow may occur when reducing the amount of filler 81 in the first layer 801, and a smaller bow may occur when increasing the amount of filler 81 in the first layer 801.

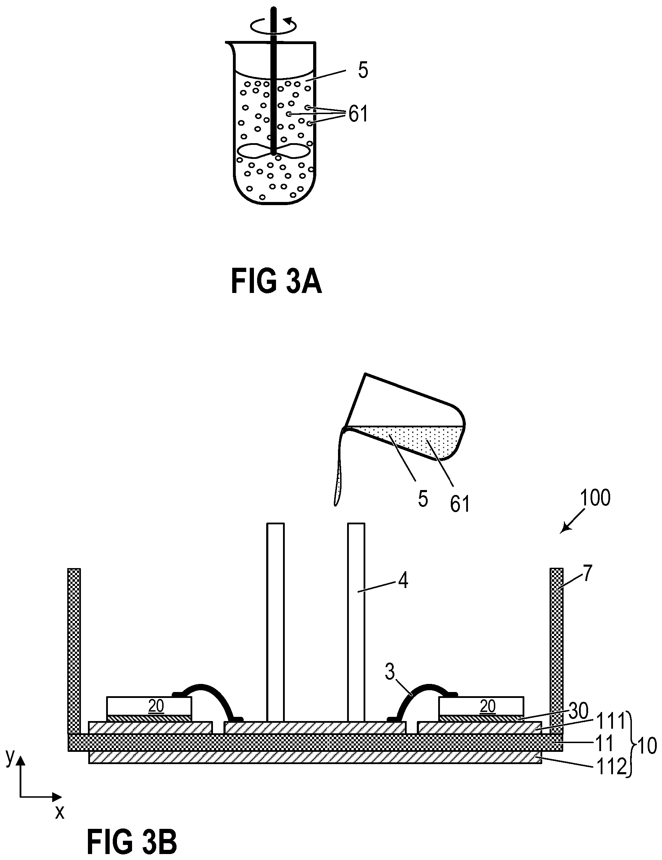

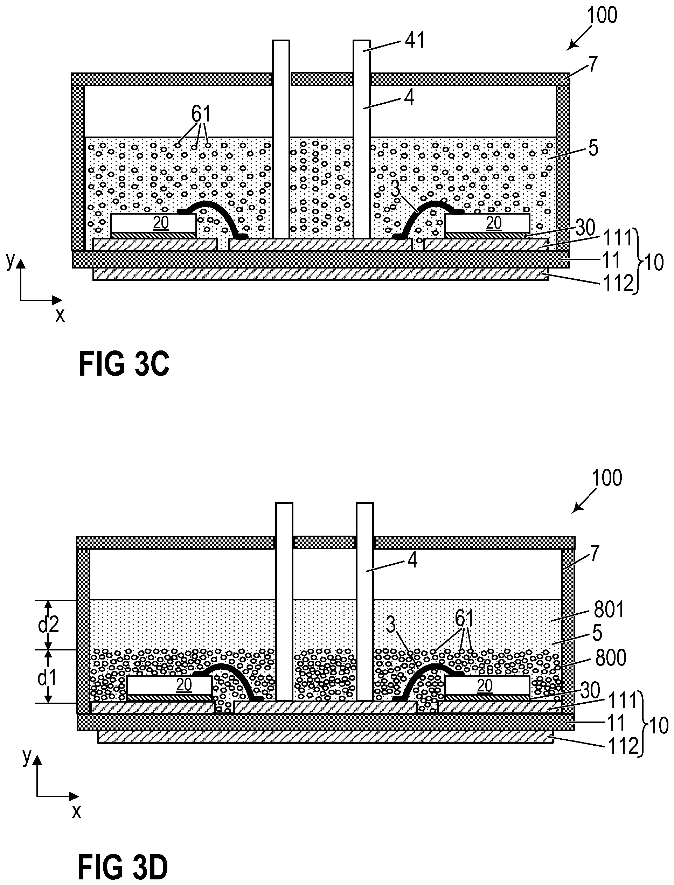

Figure 2 illustrates one embodiment falling within the scope of the claims of a power semiconductor module arrangement 100 after forming the first layer 800 and the second layer 801. A method for producing the power semiconductor module arrangement of Figure 2 is now explained by means of Figure 3, including Figures 3A to 3D, wherein Figs. 3A to 3D fall within the scope of the claims.

Figure 3B illustrates a power semiconductor module arrangement 100 before forming the first layer 800 and the second layer 801. The power semiconductor module arrangement 100 comprises a semiconductor substrate 10. The semiconductor substrate 10 corresponds to the semiconductor substrate 10 as has been described with respect to Figures 1 and 2 above. As has been described above, one or more semiconductor bodies 20 are arranged on the semiconductor substrate 10. The power semiconductor module arrangement 100 may further comprise terminal elements 4, as has already been described above. The housing 7 of the power semiconductor module arrangement 100 essentially corresponds to the housing 7 as has been described with respect to Figures 1 and 2 above. A cover, however, may be added to the housing 7 at a later stage, e.g., after forming the first and second layers 800, 801. It is also possible that the housing 7 of the arrangement as illustrated in Figure 3B further comprises a bottom. Instead, the semiconductor substrate 10 may also be arranged on a base plate (not illustrated), the base plate forming a bottom of the housing 7. As is schematically illustrated in Figure 3A, the inorganic filler 81 is pre-mixed with the casting compound 5. For example, the particles of the filler 81 may be evenly distributed within the casting compound 5. The material of the casting compound 5 may be liquid or viscous, for example.

The mixture comprising the casting compound 5 and the filler 81 is then filled into the semiconductor module, as is illustrated in Figure 3B. Figure 3C schematically illustrates the semiconductor module arrangement 100 after filling the mixture into the housing 7. As can be seen, at this point the filler 81 is still evenly distributed within the casting compound 5. However, as the density $\rho_f$ of the filler 81 is greater than the density $\rho_{cc}$ of the casting compound 5, the filler 81 settles down on the surface of the semiconductor substrate 10 and the semiconductor bodies 20 and any other elements mounted on the semiconductor substrate 10. As is schematically illustrated in Figure 3D, in this way a dense first layer 800 is formed by the descended filler 81. As has been described above, the filler 81 may include particles. The particles may have a generally rounded or oval shape, for example. Any other form of the particles, however, is also possible. After settling down, the particles of the filler 81 are stacked on top of each other. However, spaces or gaps remain between the different particles of the filler 81. A part of the casting compound 5 fills these spaces or gaps. The first layer 800, therefore, is a comparably dense layer formed by letting the filler 81 settle down within the casting compound 5. The concentration of filler 81 within the first layer 800 is significantly higher than the concentration of filler 81 in the pre-mixed mixture that is filled into the housing 7.

The remaining part of the casting compound forms the second layer 801 arranged on the first layer 800. As the filler 81 descends onto the semiconductor substrate 10, no filler 81 remains in the second layer 801. The thickness d1 of the first layer 800 and the thickness d2 of the second layer 801 depend on the amount of casting compound 5 and filler 81 that is used to form the pre-mixed mixture (see Figure 3A).

The settling of the filler 81 is accelerated by heating the semiconductor module arrangement 10 during the step of settling. By applying heat, the density of the casting compound 5 is reduced, thereby liquefying the material of the casting compound (viscosity of casting compound 5 is reduced). The filler 81, therefore, may settle much faster at higher temperatures than at lower temperatures. The temperature during the settling step may be between 30 and 150°C, for example.

The settling of the filler 81 may be performed within a vacuum. For example, a vacuum of 1 to 200 mbar may be created. Additionally to heating the semiconductor module arrangement, it is also possible to accelerate the settling of the filler 81 by reducing the vacuum level during the settling step. The temperature as well as the vacuum level may depend on the material that is used for the casting compound 5.

Once the filler 81 has completely settled, a curing or hardening step is performed (not specifically illustrated). When curing or hardening the casting material 5, the casting material 5 cross-links with the inorganic filler 81. This significantly reduces the mobility of the inorganic filler 81. By essentially filling all remaining spaces and gaps between the particles of the inorganic filler 81, as well as by cross-linking the casting material 5 and the inorganic fillers, it becomes difficult or even impossible for any gases to diffuse through the first layer 800.

Curing or hardening the casting material 5 may comprise heating the casting material 5 and evaporating all or most of the liquid of the casting compound 5, for example. Instead or curing the casting material 5 or after curing the casting material 5, the casting material 5 may be cooled down to below its glass transition temperature, for example. For example, the casting material 5 may be cooled down to room temperature, which is usually far below the glass transition temperature of the materials that are used as the casting compound 5.

The particles of the inorganic filler 81 are generally stacked onto each other in a random manner. Therefore, if anything, gases cannot diffuse through the first layer 800 in a straight line. Generally, gases cannot penetrate through the inorganic filler 81, but only through the casting material 5 surrounding the filler 81. Gases, therefore, have to diffuse around the inorganic fillers 81, which results in a comparatively long diffusion path. This makes it more difficult for gases to diffuse through the first layer 800. Generally, as the amount of inorganic filler 81 is comparatively high in the first layer 800, there is very little space for gases to diffuse through the first layer 800. This makes it almost impossible for corrosive gases to diffuse through the first layer 800.

As can be seen in Figure 2 and as has been described above, the concentration of filler 81 is very high within the first layer 800 adjacent to the semiconductor substrate 10 and the semiconductor bodies 20 mounted thereon. On the other hand, the second layer 801 does not comprise any filler 81. In this way, the elastic modulus of the filling material may be increased as compared to the arrangement of Figure 1, for example, and the CTE of the first layer 800 may be reduced as compared to a layer comprising only the casting compound 5. The CTE of the first layer 800 in this way may be adjusted to the CTE of the semiconductor substrate 10 and the semiconductor bodies 20. The CTE can be adjusted by adjusting the concentration of the filler 81 within the casting compound 5. The resulting semiconductor module arrangement 100 is stable at high temperatures, e.g., above 200°C.

**Claims**

1. A method for producing a power semiconductor module arrangement (100) comprises:

   mixing inorganic fillers (81) with a casting material (5), thereby preparing a mixture comprising a first concentration of inorganic fillers (81), wherein the inorganic fillers (81) have a density ($\rho_f$) that is higher than the density ($\rho_{cc}$) of the casting material (5);
   filling the mixture comprising the inorganic fillers (81) and the casting material (5) into a housing (7), wherein a semiconductor substrate (10) is arranged within the housing (7), the semiconductor substrate (10) including a dielectric insulation layer (11) and at least a first metallization layer (111) attached to the dielectric insulation layer (11), and wherein at least one semiconductor body (20) is arranged on a top surface of the first metallization layer (111) such that the first metallization layer is arranged between the at least one semiconductor body (20) and the dielectric insulation layer (11);
   performing a settling step during which the inorganic fillers (81) completely settle down onto the semiconductor substrate (10) and the at least one semiconductor body (20), thereby forming a first layer (800) comprising a portion of the casting material (5) and the inorganic fillers (81), and a second layer (801) comprising a remaining portion of the casting material (5) without inorganic fillers (81), wherein during the settling step, the power semiconductor module arrangement (100) is heated, thereby reducing the viscosity of the casting material (5); and
   hardening the casting material (5).

2. The method of claim 1, wherein the inorganic fillers (81) has a density ($\rho_f$) of between 0.9 and 5.0 g/cm$^3$, and wherein the casting material (5) has a density ($\rho_{cc}$) of between 0.2 and 0.9 g/cm$^3$.

3. The method of claim 1 or 2, wherein the amount of the inorganic fillers (81) in the first layer (800) is between about 20 and 90vol%, or between about 60 and 80vol%.

4. The method of any of claims 1 to 3, wherein the casting material (5) comprises a non-reactive cross-linkable or non-cross-linkable polymer.

5. The method of claim 4, wherein the polymer comprises silicone gel, silicone rubber or epoxy resin.

6. The method of any of the preceding claims, wherein the inorganic fillers (81) comprises at least one of silica, fused silica, crystalline silica, precipitated silica, alumina, beryllium, boron nitride, aluminum nitride, silicon nitride, silicon carbide, boron carbide, titanium carbide, magnesium oxide, zinc oxide, or glass fiber.

7. The method of any of the preceding claims, wherein the inorganic fillers (81) comprises particles with a diameter of between 1 and 400$\mu$m, or between about 4 and 20$\mu$m.

8. The method of any of the preceding claims, wherein the first layer (800) is arranged between the second layer (801) and the semiconductor substrate (10).

9. The method of any of the preceding claims, wherein the first layer (800) has a coefficient of thermal expansion ($CTE_{800}$) that is similar to a coefficient of thermal expansion ($CTE_{10}$, $CTE_{20}$) of the semiconductor substrate (10) and the at least one semiconductor body (20) such that $CTE_{800} = CTE_{10} \pm$ 5ppm/K, and $CTE_{800} = CTE_{20} \pm$ 5ppm/K.

10. The method of any of the preceding claims, wherein

the first layer (800) has a first thickness (d1) in a vertical direction (y) perpendicular to the top surface of the semiconductor substrate (10);

the second layer (801) has a second thickness (d2) in the vertical direction (y); and

the second thickness (d2) is the same as, smaller or greater than the first thickness (d1).

11. The method of any of the preceding claims, further comprising

performing the step of settling within a vacuum.

**Patentansprüche**

1. Verfahren zur Herstellung einer Leistungshalbeitermodulanordnung (100), umfassend:

Mischen anorganischer Füllstoffe (81) mit einem Gussmaterial (5), wodurch ein Gemisch hergestellt wird, das eine erste Konzentration anorganischer Füllstoffe (81) umfasst, wobei die anorganischen Füllstoffe (81) eine Dichte ($\rho_f$) aufweisen, die höher als die Dichte ($\rho_{cc}$) des Gussmaterials (5) ist;

Füllen des Gemischs, das die anorganischen Füllstoffe (81) und das Gussmaterial (5) umfasst, in ein Gehäuse (7), wobei ein Halbleitersubstrat (10) innerhalb des Gehäuses (7) angeordnet ist, wobei das Halbleitersubstrat (10) eine dielektrische Isolationsschicht (11) und mindestens eine erste Metallisierungsschicht (111) umfasst, die an der dielektrischen Isolationsschicht (11) angebracht ist, und wobei mindestens ein Halbleiterbody (20) so auf einer oberen Oberfläche der ersten Metallisierungsschicht (111) angeordnet ist, dass die erste Metallisierungsschicht zwischen dem mindestens einen Halbleiterbody (20) und der dielektrischen Isolationsschicht (11) angeordnet ist;

Durchführen eines Absetzschritts, während dessen sich die anorganischen Füllstoffe (81) vollständig auf dem Halbleitersubstrat (10) und dem mindestens einen Halbleiterbody (20) absetzen, wodurch eine erste Schicht (800), die einen Teil des Gussmaterials (5) und die anorganischen Füllstoffe (81) umfasst, und eine zweite Schicht (801) gebildet werden, die einen übrigen Teil des Gussmaterials (5) ohne anorganische Füllstoffe (81) umfasst, wobei während des Absetzschritts die Leistungshalbleitermodulanordnung (100) erwärmt wird, wodurch die Viskosität des Gussmaterials (5) verringert wird; und

Aushärten des Gussmaterials (5).

2. Verfahren nach Anspruch 1, wobei die anorganischen Füllstoffe (81) eine Dichte ($\rho_f$) zwischen 0,9 und 5,0 g/cm$^3$ aufweisen und wobei das Gussmaterial (5) eine Dichte ($\rho_{cc}$) zwischen 0,2 und 0,9 g/cm$^3$ aufweist.

3. Verfahren nach Anspruch 1 oder 2, wobei die Menge der anorganischen Füllstoffe (81) in der ersten Schicht (800) zwischen etwa 20 und 90 Vol.-% oder zwischen etwa 60 und 80 Vol.-% liegt.

4. Verfahren nach einem der Ansprüche 1 bis 3, **dadurch gekennzeichnet, dass** das Gussmaterial (5) ein nicht reaktives, vernetzbares oder nicht vernetzbares Polymer umfasst.

5. Verfahren nach Anspruch 4, wobei das Polymer Silikongel, Silikonkautschuk oder Epoxidharz umfasst.

6. Verfahren nach einem der vorhergehenden Ansprüche, **dadurch gekennzeichnet, dass** die anorganischen Füllstoffe (81) mindestens eines von Siliciumdioxid, Quarzglas, kristallinem Siliciumdioxid, gefälltem Siliciumdioxid, Aluminiumoxid, Beryllium, Bornitrid, Aluminiumnitrid, Siliciumnitrid, Siliciumcarbid, Borcarbid, Titancarbid, Magnesiumoxid, Zinkoxid oder Glasfaser umfassen.

7. Verfahren nach einem der vorhergehenden Ansprüche, **dadurch gekennzeichnet, dass** die anorganischen Füllstoffe (81) Teilchen mit einem Durchmesser zwischen 1 und 400 $\mu$m oder zwischen etwa 4 und 20 $\mu$m umfassen.

8. Verfahren nach einem der vorhergehenden Ansprüche, wobei die erste Schicht (800) zwischen der zweiten Schicht (801) und dem Halbleitersubstrat (10) angeordnet ist.

9. Verfahren nach einem der vorangehenden Ansprüche, wobei die erste Schicht (800) einen Wärmeausdehnungskoeffizienten ($CTE_{800}$) aufweist, der einem Wärmeausdehnungskoeffizienten ($CTE_{10}$, $CTE_{20}$) des Halbleitersubstrats (10) und des mindestens einen Halbleiterbodys (20) ähnelt, so dass $CTE_{800} = CTE_{10} \pm 5$ ppm/K und $CTE_{800} = CTE_{20} \pm 5$ ppm/K.

10. Verfahren nach einem der vorstehenden Ansprüche, wobei

die erste Schicht (800) eine erste Dicke (d1) in einer vertikalen Richtung (y) senkrecht zur oberen Oberfläche des Halbleitersubstrats (10) aufweist;

die zweite Schicht (801) eine zweite Dicke (d2) in der vertikalen Richtung (y) aufweist; und

die zweite Dicke (d2) gleich wie, kleiner oder größer als die erste Dicke (d1) ist.

**11.** Verfahren nach einem der vorhergehenden Ansprüche, ferner umfassend:
Ausführen des Absetzschritts innerhalb eines Vakuums.

## Revendications

**1.** Un procédé de production d'un agencement (100) de module à semiconducteur de puissance comprend :

mélanger des charges (81) minérales à une matière (5) de coulée, en préparant ainsi un mélange comprenant une première concentration de charges (81) minérales, les charges (81) minérales ayant une masse volumique ($\rho_f$), qui est plus grande que la masse volumique ($\rho_{cc}$) de la matière (5) de coulée ;
remplir un boîtier (7) du mélange comprenant les charges (81) minérales et la matière (5) de coulée, un substrat (10) à semiconducteur étant disposé dans le boîtier (7), le substrat (10) à semiconducteur comprenant une couche (11) diélectrique d'isolation et au moins une première couche (111) de métallisation fixée à la couche (11) diélectrique d'isolation, et dans lequel au moins un corps (20) à semiconducteur est disposé sur une surface de sommet de la première couche (111) de métallisation, de manière à ce que la première couche de métallisation soit disposée entre le au moins un corps (20) à semiconducteur et la couche (11) diélectrique d'isolation ;
effectuer un stade de décantation, pendant lequel les charges (81) minérales se déposent complètement sur le substrat (10) à semiconducteur et le au moins un corps (20) à semiconducteur, en formant ainsi une première couche (800) comprenant une partie de la matière (5) de coulée et les charges (81) minérales et une deuxième couche (801) comprenant une partie restante de la matière (5) de coulée sans charge (81) minérale, dans lequel, pendant le stade de décantation, on chauffe l'agencement (100) de module à semiconducteur de puissance, en réduisant ainsi la viscosité de la matière (5) de coulée ; et
durcir la matière (5) de coulée.

**2.** Le procédé de la revendication 1, dans lequel les charges (81) minérales ont une masse volumique ($\rho_f$) comprise entre 0,9 et 5,0 g/cm$^3$, et dans lequel la matière (5) de coulée a une masse volumique ($\rho_{cc}$) comprise entre 0,2 et 0,9 g/cm$^3$.

**3.** Le procédé de la revendication 1 ou 2, dans lequel la quantité des charges (81) minérales dans la première couche (800) est comprise entre environ 20 et 90 % en volume, ou entre environ 60 et 80 % en volume.

**4.** Le procédé de l'une quelconque des revendications 1 à 3, dans lequel la matière (5) de coulée comprend un polymère non réactif réticulable ou non réticulable.

**5.** Le procédé de la revendication 4, dans lequel le polymère comprend un gel de silicone, du caoutchouc de silicone ou de la résine époxy.

**6.** Le procédé de l'une quelconque des revendications précédentes, dans lequel les charges (81) minérales comprennent au moins l'un de la silice, de la silice fondue, de la silice cristalline, de la silice précipitée, de l'oxyde d'aluminium, du béryllium, du nitrure de bore, du nitrure d'aluminium, du nitrure de silicium, du carbure de silicium, du carbure de bore, du carbure de titane, de l'oxyde de magnésium, de l'oxyde de zinc ou de la fibre de verre.

**7.** Le procédé de l'une quelconque des revendications précédentes, dans lequel les charges (81) minérales comprennent des particules d'un diamètre compris entre 1 et 400 $\mu$m, ou compris entre environ 4 et 20 $\mu$m.

**8.** Le procédé de l'une quelconque des revendications précédentes, dans lequel la première couche (800) est disposée entre la deuxième couche (801) et le substrat (10) à semiconducteur.

**9.** Le procédé de l'une quelconque des revendications précédentes, dans lequel la première couche (800) a un coefficient de dilatation thermique ($CTE_{800}$), qui est semblable à un coefficient de dilatation thermique ($CTE_{10}$, $CTE_{20}$) du substrat (10) à semiconducteur et du au moins un corps (20) à semiconducteur, de manière à ce que $CTE_{800} = CTE_{10} \pm$ 5ppm/K, et $CTE_{800} = CTE_{20} \pm$ 5ppm/K.

**10.** Le procédé de l'une quelconque des revendications précédentes, dans lequel

la première couche (800) a une première épaisseur (d1) dans une direction (y) verticale perpendiculaire à la surface de sommet du substrat (10) à semiconducteur ;
la deuxième couche (801) a une deuxième épaisseur (d2) dans une direction (y) verticale ; et
la deuxième épaisseur (d2) est égale, inférieure ou supérieure à la première épaisseur (d1).

**11.** Le procédé de l'une quelconque des revendications précédentes, comprenant en outre
effectuer le stade de décantation dans un vide.

**FIG 1**

**FIG 2**

**FIG 3A**

**FIG 3B**

**FIG 3C**

**FIG 3D**

**FIG 4**

**EP 3 731 267 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2002070439 A1
- EP 1933610 A1
- EP 3276660 A1
- EP 3511977 A1